# EUROPEAN PATENT APPLICATION

(11) **EP 4 761 541 A1**
(43) Date of publication of application: **17.06.2026**
(21) Application number: 25217348.9
(22) Date of filing: 20.11.2025
(51) Int. Cl.: H10K 59/124, H10H 29/01, H10H 29/41

(54) **TRANSPARENT DISPLAY DEVICE AND MANUFACTURING METHOD THEREOF**

(30) Priority: 11.12.2024 US 202463730461 P; 27.06.2025 CN 202510875074
(71) Applicant: InnoLux Corporation, Miao-Li County 350 (TW)
(72) Inventor: LAI, Tzu-Chieh, 350 Miao-Li County (TW); TSAI, Ming-Chih, 350 Miao-Li County (TW); TU, Yu-Wei, 350 Miao-Li County (TW); CHANG, Chun-Hsiang, 350 Miao-Li County (TW); TSAI, Chia-Hao, 350 Miao-Li County (TW); WU, Yung-Hsun, 350 Miao-Li County (TW)
(74) Representative: Straus, Alexander

(57) **Abstract**

A transparent display device (TD) and a manufacturing method thereof are provided. The transparent display device (TD) includes a substrate (100), a inorganic layer (210) disposed on the substrate (100), a driving element layer (DEL) disposed on the inorganic layer (210), a first organic layer (410) disposed on the driving element layer (DEL), a second organic layer (420) disposed on the first organic layer (410), and a light emitting element (600) disposed on the second organic layer (420), wherein the first organic layer (410) includes a side surface (SF1), and the second organic layer (420) is disposed on the side surface (SF1) of the first organic layer (410).

## Description

### Field of the Disclosure

The present disclosure relates to a transparent display device, and particularly to a transparent display device with a transparent region.

### Background of the Disclosure

With the advancement of technology, various types of display devices have been developed. Among them, transparent display devices have become one of the key focuses in the industry owing to their ability to allow users to clearly view the background behind the display. Conventional transparent display devices include a transparent region and a non-transparent region. In order to enhance the display quality of the transparent region, multiple etching processes are typically employed to remove multilayer insulating layers within the transparent region. However, since the material of the substrate is similar to the material of the insulating layers, the etching solution used in the etching process can also damage the substrate, resulting in increased surface roughness and haze on the substrate, which affects the transmittance of the transparent display device and degrades the user experience. Therefore, how to improve the transparency and transmittance of transparent display devices remains one of the technical challenges to be addressed in the industry.

### Summary of the Disclosure

This in mind, the present disclosure aims at providing a transparent display device and a manufacturing method thereof to reduce surface roughness and haze on the substrate and/or enhance the transmittance.

This is achieved by a transparent display device and a manufacturing method thereof, in which multiple inorganic insulating layers are etched in a single etching process, according to the independent claim. The dependent claims pertain to corresponding further developments and improvements.

As will be seen more clearly from the detailed description following below, the claimed transparent display device includes a substrate, a first inorganic layer disposed on the substrate, a driving element layer disposed on the first inorganic layer, a first organic layer disposed on the driving element layer, a second organic layer disposed on the first organic layer, and a light emitting element disposed on the second organic layer, wherein the first organic layer includes a side surface, and the second organic layer is disposed on the side surface of the first organic layer.

As will be seen more clearly from the detailed description following below, the claimed manufacturing method of a transparent display device includes providing a substrate, forming a first inorganic layer on the substrate, forming a driving element layer on the first inorganic layer, forming a first organic layer on the driving element layer, patterning the first organic layer to form a first opening and a first side surface, forming a second inorganic layer on the first organic layer, forming a second organic layer on the second inorganic layer, forming a third inorganic layer on the second organic layer, patterning the first inorganic layer, the second inorganic layer, and the third inorganic layer to form an opening structure, and disposing a light emitting element on the third inorganic layer. The second inorganic layer covers the first side surface of the first organic layer and the first inorganic layer. The second organic layer is disposed on the first side surface of the first organic layer. The third inorganic layer covers the second inorganic layer. The opening structure overlaps the first opening.

### Brief Description of the Drawings

In the following, the disclosure is further illustrated by way of example, taking reference to the accompanying drawings. Thereof:
FIG. 1 to FIG. 5 schematically illustrates a cross-sectional view of a transparent display device in different steps according to a first embodiment of the present disclosure;
FIG. 6 schematically illustrates a top view of a transparent display device according to the first embodiment of the present disclosure;
FIG. 7 schematically illustrates a top view of a transparent display device according to a second embodiment of the present disclosure;
FIG. 8 schematically illustrates a cross-sectional view of a transparent display device according to the second embodiment of the present disclosure;
FIG. 9 schematically illustrates a cross-sectional view of a transparent display device according to a variant embodiment of the second embodiment of the present disclosure; and
FIG. 10 is a schematic cross-sectional view in one step of a manufacturing method of a transparent display device according to the third embodiment of the present disclosure.

### Detailed Description

The contents of the present disclosure will be described in detail with reference to specific embodiments and drawings. It is noted that, for purposes of illustrative clarity and ease of understanding by the readers, the following drawings in the present disclosure may be a simplified illustrations, and elements therein may not be drawn to scale. The numbers and sizes of the elements in the drawings are merely illustrative and are not intended to limit the scope of the present disclosure.

Certain terms are used throughout the specification and the appended claims of the present disclosure to refer to specific elements. Those skilled in the art should understand that electronic equipment manufacturers may refer to an element by different names, and this document does not intend to distinguish between elements that differ in name but not in function. In the following specification and claims, the terms "comprise", "include" and "have" are open-ended fashion, so they should be interpreted as "including but not limited to...".

The ordinal numbers used in the specification and the appended claims, such as "first", "second", etc., are used to describe the elements of the claims. This does not mean that the element has any previous ordinal numbers, nor does this represent the order of a certain element and another element, or the sequence in a manufacturing method. These ordinal numbers are merely used to make a claimed element with a certain name be clearly distinguishable from another claimed element with the same name.

In addition, when one element or layer is "connected to" another element or layer, it may be understood that the element or layer is directly connected to the another element or layer physically or electrically, and alternatively, the two may be physically or electrically connected through other element or layer (indirectly). When the element or layer is "directly connected to" another element or layer, it may be understood that there is no other element or layer between the two for physical or electrical connection. The term "connect" may include means of "directly connect" or "indirectly connect". Besides, the term "electrically connect" or "couple" includes any direct or indirect means of electrical connection.

In the present disclosure, when one element is "disposed on" another element, the manufacturing procedure or sequence of forming the element and the another element is not limited thereto. In the present disclosure, when one element is "disposed on" another element, it may include one element is disposed on a side wall of another element.

As disclosed herein, the terms "approximately", "about", or "substantially" generally mean within 10%, 5%, 3%, 2%, 1%, or 0.5% of the reported numerical value or range. The numbers given herein are approximated numbers, and that is, without specifically describing with the terms "approximately", "about", or "substantially", it may still imply the meaning of the terms "approximately", "about", or "substantially".

The term "between a number A and a number B" is interpreted as including the number A and the number B or as including at least one of the number A and the number B, and as including other numbers between the number A and the number B.

In the present disclosure, the depth, length, thickness, width, height, distance, and aperture may be measured by using an optical microscope (OM), a scanning electron microscope (SEM) or other approaches, but not limited thereto.

It should be understood that, according to the following embodiments, features of different embodiments may be replaced, recombined or mixed to constitute other embodiments without departing from the spirit of the present disclosure. The features of various embodiments may be mixed arbitrarily and used in different embodiments without departing from or conflicting with the spirit of the present disclosure.

Unless otherwise defined, all terms (including technical and scientific terms) used herein have the same meaning as commonly understood by those skilled in the art. It should be understood that these terms, such as those defined in commonly used dictionaries, should be interpreted as having meaning consistent with the relevant technology and the background or context of the present disclosure, and should not be interpreted in an idealized or excessively formal way, unless there is a specific definition in the embodiments of the present disclosure.

A transparent display device of the present disclosure may, for example, be applied to any kinds of electronic devices. The electronic device may, for example, include a display device, a light emitting device, a sensing device, an antenna device, a touch device, a tiled device, or other suitable electronic devices, but not limited thereto. The display device may, for example, be applied to a laptop, a public display, a tiled display, a car display, a touch display, a TV, a monitor, a smartphone, a tablet, a light source module, a lighting equipment, a military equipment, a medical equipment, or an electronic device applied to the aforementioned products, but not limited thereto. The display device may, for example, include liquid crystal molecules, a light emitting diode, a fluorescent material, a phosphor material, other suitable display media, or a combination of the aforementioned display media, but not limited thereto. The light emitting diode may, for example, include an organic light emitting diode (OLED), a mini light emitting diode (mini LED), a micro light emitting diode (micro LED), or a quantum dot light emitting diode (e.g., QLED or QDLED), but not limited thereto. The tiled device may, for example, include a tiled display device or a tiled antenna device, but not limited thereto. The electronic device may include electronic units, in which the electronic units may include a passive element and an active element, and for example, include a capacitor, a resistor, an inductor, a diode, a transistor, a sensor, etc. It is noted that the electronic device of the present disclosure may be any combination of the above-mentioned devices, but not limited thereto.

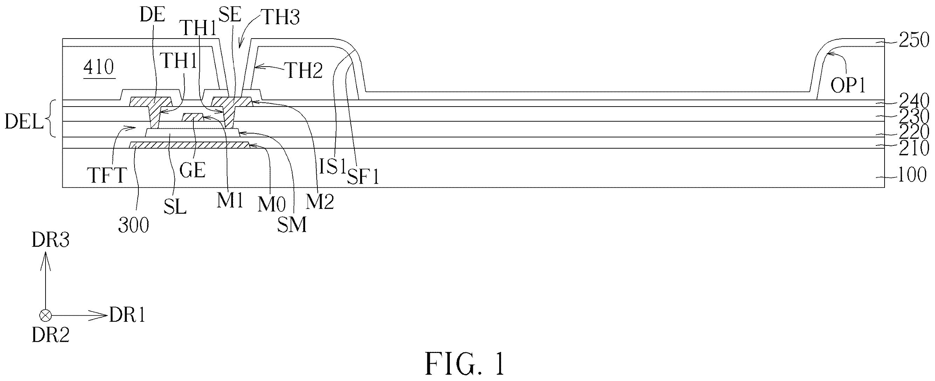

Refer to FIG. 1 to FIG. 5. FIG. 1 to FIG. 5 schematically illustrates cross-sectional views of a transparent display device in different steps according to a first embodiment of the present disclosure. As shown in FIG. 1 to FIG. 5, the manufacturing method of the transparent display device provided in this embodiment includes the following steps: providing a substrate 100; forming a first inorganic layer (e.g., inorganic layer 210 described below) on the substrate 100; forming a driving element layer DEL on the first inorganic layer; forming a first organic layer 410 on the driving element layer DEL; patterning the first organic layer 410 to form a first opening OP1 and a side surface SF1; forming a second inorganic layer (e.g., inorganic layers 250 or 260 described below) on the first organic layer 410, wherein the second inorganic layer covers the side surface SF1 of the first organic layer 410 and the first inorganic layer; forming a second organic layer 420 on the second inorganic layer, wherein the second organic layer 420 is disposed on the side surface SF1 of the first organic layer 410; forming a third inorganic layer (e.g., inorganic layers 270, 280, or 290 described below) on the second organic layer 420, wherein the third inorganic layer covers the second inorganic layer; patterning the first inorganic layer, the second inorganic layer, and the third inorganic layer to form an opening structure OPS, wherein the opening structure OPS overlaps the first opening OP1; and disposing a light emitting element 600 on the third inorganic layer.

The following content will describe the manufacturing method of the transparent display device TD of this embodiment with reference to FIG. 1 to FIG. 5. As shown in FIG. 1, after providing the substrate 100, a conductive layer M0 may be formed on the substrate 100, wherein the conductive layer M0 may include a plurality of conductive patterns 300, but is not limited thereto. FIG. 1 illustrates one of the conductive patterns 300, and the number of conductive patterns 300 is not limited to that shown in FIG. 1. The method of forming the conductive layer M0 may, for example, include a deposition process combined with photolithography and etching processes, other suitable processes, or a combination thereof. After the conductive patterns 300 are formed, the inorganic layer 210 may be formed on the substrate 100 and cover the conductive patterns 300. The conductive layer M0 may include a conductive material (e.g., metal) or other suitable materials, but is not limited thereto. In some embodiments, the conductive layer M0 may alternatively be replaced with a light shielding layer including opaque materials, light absorbing materials, or a combination thereof.

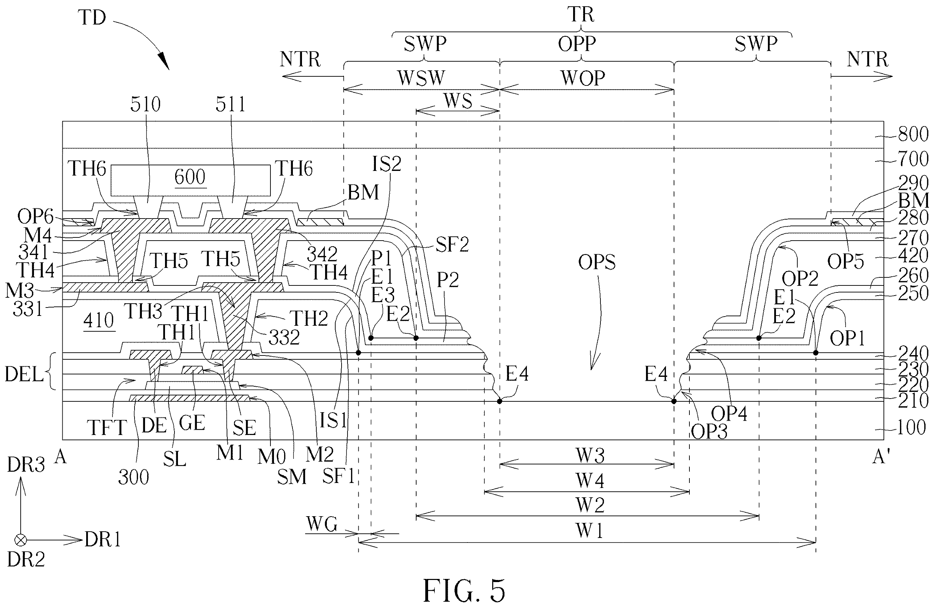

Subsequently, the driving element layer DEL may be formed on the inorganic layer 210. The driving element layer DEL may include at least one driving element electrically connected to the light emitting element 600 shown in FIG. 5, but is not limited thereto. In FIG. 1, the driving element is exemplified as a transistor TFT, but is not limited thereto. For example, the driving element layer DEL may include a plurality of transistors TFT, a plurality of signal lines, and other suitable elements. In this embodiment, the transistor TFT is described using a top-gate type as an example, but the present disclosure is not limited thereto. Specifically, as shown in FIG. 1, a semiconductor layer SM may first be formed on the inorganic layer 210, and a patterning process may be performed on the semiconductor layer SM to form a plurality of semiconductor patterns SL. After the semiconductor patterns SL are formed, an inorganic layer 220 may be formed on the inorganic layer 210 and cover the semiconductor patterns SL to serve as a gate insulating layer. The semiconductor layer SM may include, for example, amorphous silicon (a-Si), low-temperature polycrystalline silicon (LTPS), oxide semiconductors, or other suitable semiconductor materials. Afterwards, a conductive layer M1 may be formed on the inorganic layer 220, wherein the conductive layer M1 includes a plurality of gate electrodes GE respectively disposed corresponding to the semiconductor patterns SL. The method of forming the conductive layer M1 may, for example, include a deposition process combined with photolithography and etching processes, other suitable processes, or a combination thereof.

After the gate electrode GE is formed, an inorganic layer 230 may be formed on the inorganic layer 220 and cover the gate electrode GE. Subsequently, the inorganic layers 220 and 230 may be patterned to form a plurality of through holes TH1, two of the through holes TH1 may correspond to and expose two ends of the semiconductor pattern SL. A conductive layer M2 may then be formed on the inorganic layer 230 and filled into the through holes TH1, wherein the conductive layer M2 may include a plurality of drain electrodes DE and a plurality of source electrodes SE. The method of forming the conductive layer M2 may be the same as or similar to that of forming the conductive layer M1, and will not be repeated here. In this embodiment, one of the semiconductor patterns SL, a portion of the inorganic layer 220, one of the gate electrodes GE, a portion of the inorganic layer 230, one of the drain electrodes DE, and one of the source electrodes SE may constitute one of the transistors TFT, wherein the conductive patterns 300 may be respectively disposed corresponding to the semiconductor patterns SL of the transistors TFT, but is not limited thereto. Then, an inorganic layer 240 may be formed on the conductive layer M2, thereby forming the driving element layer DEL. In this embodiment, the semiconductor layer SM, the inorganic layer 220, the conductive layer M1, the inorganic layer 230, the conductive layer M2, and the inorganic layer 240 may constitute the driving element layer DEL, but are not limited thereto. For example, by disposing the conductive pattern 300, the leakage current generated when the transistor TFT is exposed to light may be reduced, thereby improving the display quality of the transparent display device TD, but is not limited thereto. It should be noted that in the present disclosure, the source electrode SE and the drain electrode DE may be interchanged according to actual design requirements. Following embodiments of the present disclosure may also adopt this configuration.

After the driving element layer DEL is formed, the first organic layer 410 may be formed on the driving element layer DEL, and the first organic layer 410 may be patterned to form at least one first opening OP1 and at least one side surface SF1, wherein the side surface SF1 may be, for example, a sidewall of the first opening OP1. The step of patterning the first organic layer 410 may further form at least one through hole TH2, exposing a portion of the inorganic layer 240 corresponding to the source electrode SE, in the first organic layer 410.

Subsequently, the inorganic layer 250 may optionally be formed on the first organic layer 410, wherein the inorganic layer 250 may cover the first organic layer 410 and the inorganic layer 210. In other words, the inorganic layer 250 may extend into the through hole TH2 and the first opening OP1, thereby covering the side surface SF1 of the first organic layer 410, such that the portion of the inorganic layer 250 corresponding to the side surface SF1 may have an inclined surface IS1. It should be noted that in the present disclosure, one element "covers" another element may refer to the overlapping of the two elements in a direction DR3, wherein the direction DR3 may be parallel to a normal direction of the substrate 100, but is not limited thereto. After the inorganic layer 250 is formed, portions of the inorganic layers 240 and 250 corresponding to the through hole TH2 may be patterned to form at least one through hole TH3, such that a portion of the source electrode SE is exposed.

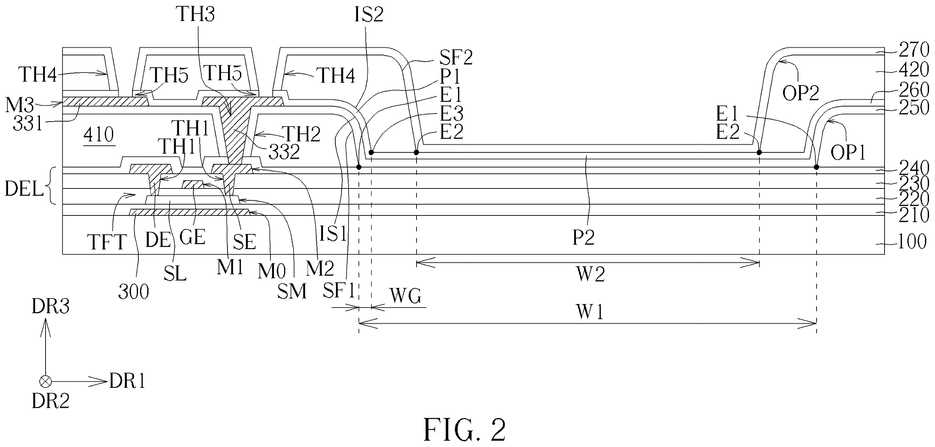

Next, as shown in FIG. 2, a conductive layer M3 may optionally be formed on the inorganic layer 250 and filled into the through hole TH3 of the inorganic layers 240 and 250, wherein the conductive layer M3 includes conductive patterns 331 and 332. The conductive pattern 332 may be electrically connected to the source electrode SE through the through hole TH3. The conductive pattern 332 may, for example, directly contact the source electrode SE, but is not limited thereto. The method of forming the conductive layer M3 may be the same as or similar to that of forming the conductive layer M1, and will not be repeated here. It should be noted that since organic layers tend to absorb moisture, the inorganic layer 250 disposed between the first organic layer 410 and the conductive layer M3 may help reduce the impact of moisture on the quality of the conductive layer M3.

In this embodiment, after the conductive patterns 331 and 332 are formed, the inorganic layer 260 may optionally be formed on the inorganic layer 250, and the inorganic layer 260 covers the conductive patterns 331 and 332. Subsequently, the second organic layer 420 may be formed on the inorganic layer 260 (or the inorganic layer 250), wherein the second organic layer 420 may be disposed on the side surface SF1 of the first organic layer 410, and may also be disposed on the inclined surface IS1 of the inorganic layer 250. In other words, the inorganic layer 250 may be disposed between the first organic layer 410 and the second organic layer 420. In this embodiment, the inorganic layers 250 and 260 may be disposed between the first organic layer 410 and the second organic layer 420, but are not limited thereto.

Next, the second organic layer 420 may be patterned to form a second opening OP2 and a side surface SF2, wherein the second opening OP2 may overlap the first opening OP1 of the first organic layer 410. The step of patterning the second organic layer 420 may further form at least two through holes TH4, exposing portions of the inorganic layer 260 corresponding to the conductive patterns 331 and 332, in the second organic layer 420. Then, an inorganic layer 270 may optionally be formed on the second organic layer 420, wherein the inorganic layer 270 may cover the inorganic layer 250 and the second organic layer 420. In other words, the inorganic layer 270 may extend into the through holes TH4 of the second organic layer 420 and the first opening OP1, such that the inorganic layer 270 covers the side surface SF2 of the second organic layer 420. Subsequently, at least two through holes TH5 may be formed in the portions of the inorganic layers 260 and 270 corresponding to the through holes TH4 of the second organic layer 420, so as to respectively expose portions of the conductive patterns 331 and 332.

As shown in FIG. 2, since the second organic layer 420 may cover the first organic layer 410 and may be disposed on the inclined surface IS1 of the inorganic layer 250, the width W2 of the second opening OP2 of the second organic layer 420 formed later may be less than the width W1 of the first opening OP1 of the first organic layer 410 formed earlier. It should be noted that in the present disclosure, a width of an opening of a layer may refer to the minimum width of the opening. That is, the side surface of the layer in the opening may have a bottom edge in contact with the underlying layer, and the opposite side surface may also have another bottom edge in contact with the underlying layer. The distance between these two bottom edges in a direction DR1 (also referred to as the cross-sectional direction) may be defined as the width of the opening, but is not limited thereto. Taking FIG. 2 as an example, the distance in the direction DR1 between a bottom edge E1 of the side surface SF1 on the left side of the first opening OP1 and another bottom edge E1 of another side surface SF1 on the right side of the first opening OP1 in contact with the inorganic layer 240 is the width W1 of the first opening OP1; similarly, the distance in the direction DR1 between a bottom edge E2 of the side surface SF2 on the left side of the second opening OP2 and another bottom edge E2 of another side surface SF2 on the right side of the second opening OP2 in contact with the inorganic layer 260 is the width W2 of the second opening OP2, but is not limited thereto. It should be noted that since FIG. 2 is a cross-sectional view of the transparent display device TD, the bottom edges E1 of the side surfaces SF1 of the first organic layer 410 in contact with the inorganic layer 240 are illustrated as dots. Furthermore, in the present disclosure, a direction DR2 may be perpendicular to direction DR1, and the direction DR3 may be perpendicular to both directions DR1 and DR2, but is not limited thereto.

In addition, a distance WG may be present between projections of one of the bottom edges E1 of the first organic layer 410 and the corresponding flat bottom surface of the second organic layer 420 on the same projection plane along the direction DR3, and the distance WG may be greater than or equal to 0.1 micrometer, but is not limited thereto. Specifically, since the inorganic layers 250 and 260 may be conformally disposed on the side surface SF1 of the first organic layer 410 and extend onto the driving element layer DEL, the inorganic layer 260 may cover the side surface SF1 of the first organic layer 410 and the inclined surface IS1 of the inorganic layer 250, such that a portion of the inorganic layer 260 corresponding to the side surface SF1 and the inclined surface IS1 may have an inclined surface IS2. Furthermore, in the region of the first opening OP1 of the first organic layer 410, the inorganic layer 260 may include an inclined portion P1 and a flat portion P2, wherein the inclined portion P1 may be disposed along the side surface SF1 of the first organic layer 410 and have the inclined surface IS2. The flat portion P2 may extend along the flat upper surface of the driving element layer DEL, and since the flat portion P2 does not overlap the first organic layer 410 in the direction DR3, it may be relatively flat and have a flat upper surface. As the second organic layer 420 is disposed on the inorganic layer 260, the second organic layer 420 may have a non-flat bottom surface corresponding to the inclined surface IS2 of the inorganic layer 260 and a flat bottom surface corresponding to the flat upper surface. An edge connecting the non-flat bottom surface and the flat bottom surface of the second organic layer 420 may be a turning edge E3. In addition, the distance WG may be defined as a distance between projections of the bottom edge E1 of the side surface SF1 of the first organic layer 410 and the turning edge E3 on the same projection plane (e.g., the upper surface of the substrate 100) along the direction DR3.

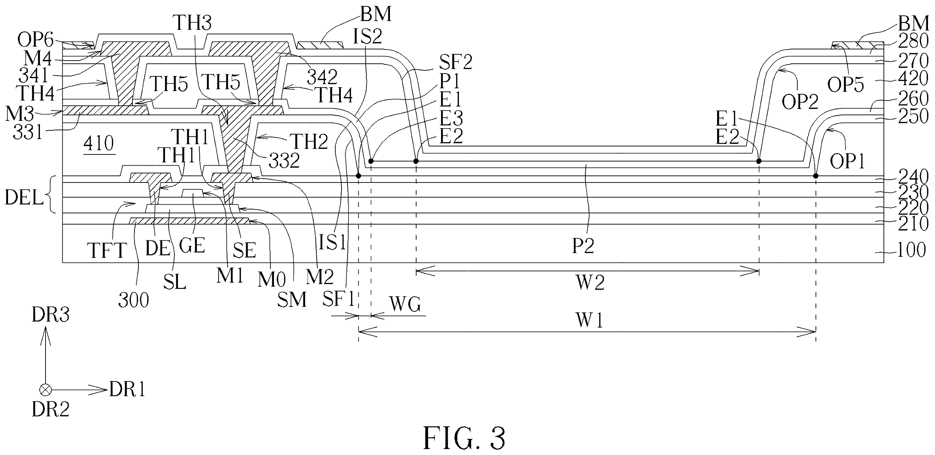

Subsequently, as shown in FIG. 3, a conductive layer M4 may optionally be formed on the inorganic layer 270, wherein the conductive layer M4 may include conductive patterns 341 and 342, which are respectively electrically connected to the conductive patterns 331 and 332. For example, the conductive patterns 341 and 342 may be disposed in the two through holes TH5 of the inorganic layers 260 and 270, and may directly contact the conductive patterns 331 and 332, respectively. The conductive pattern 342 may be electrically connected to the source electrode SE of the transistor TFT through the conductive pattern 332. The conductive patterns 341 and 342 in this embodiment may serve as contact pads, but are not limited thereto. After the conductive patterns 341 and 342 are formed, an inorganic layer 280 may optionally be formed on the second organic layer 420, wherein the inorganic layer 280 may be disposed on the conductive patterns 341 and 342 and the inorganic layer 270. At this stage, the inorganic layer 280 may cover the underlying inorganic layer 270, the second organic layer 420, the inorganic layers 260 and 250, the first organic layer 410, and the inorganic layers 240, 230, 220, and 210.

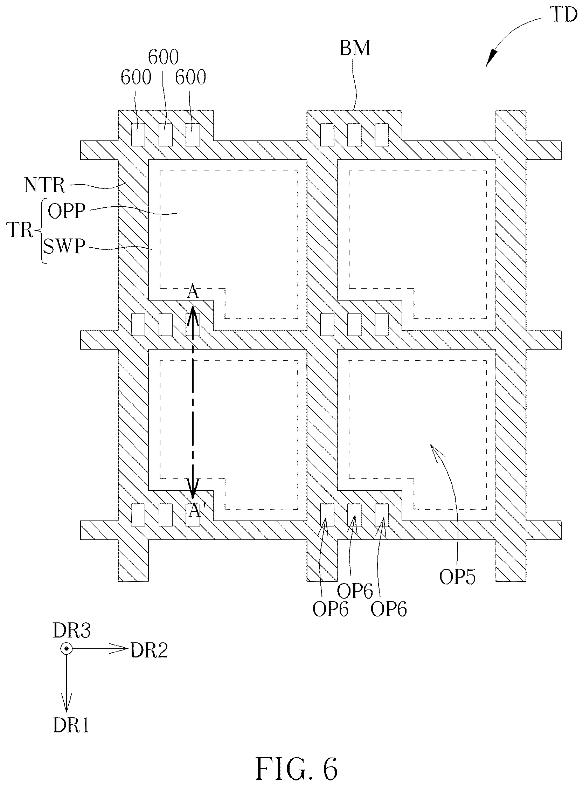

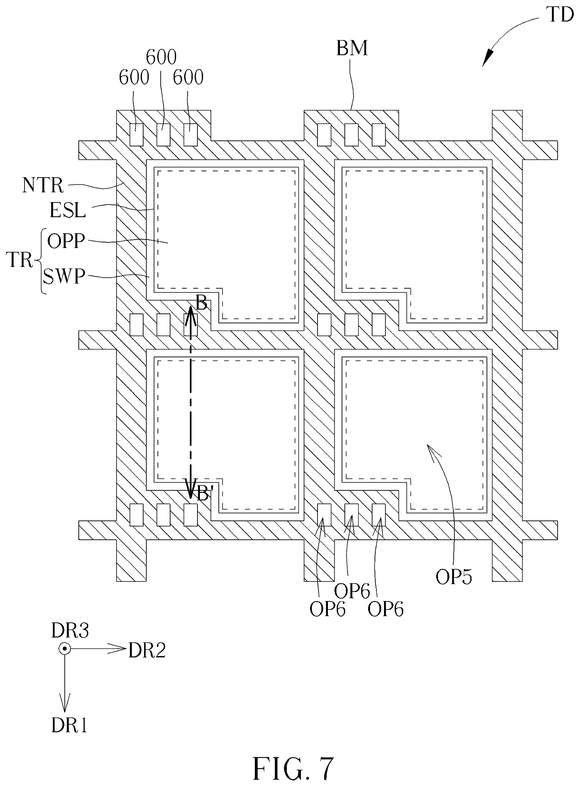

Next, a light shielding layer BM may optionally be formed on the inorganic layer 280, wherein the light shielding layer BM may have a continuous pattern in a top view (e.g., FIG. 6 or FIG. 7), and for example, the light shielding layer BM has a plurality of openings OP5 and a plurality of openings OP6. As shown in FIG. 3, one of the openings OP5 of the light shielding layer BM may correspond to the first opening OP1 of the first organic layer 410 and the second opening OP2 of the second organic layer 420, and one of the openings OP6 of the light shielding layer BM may correspond to the conductive patterns 341 and 342, but is not limited thereto. The light shielding layer BM may be, for example, a black matrix layer, and may include black metal, black resin, ink, other opaque materials, other light absorbing materials, or combinations thereof. The black metal may include, for example, molybdenum oxide (MoOx), tantalum (Ta), other suitable materials, or combinations of the aforementioned materials. In some embodiments, the transparent display device TD may not include the light shielding layer BM. In such case, the conductive layer M4 may include black metal to reduce the visibility of the conductive layer M4 and shield the underlying elements. Alternatively, other conductive layers (e.g., the conductive layers M0, M1, M2, and M3) may also respectively include black metal.

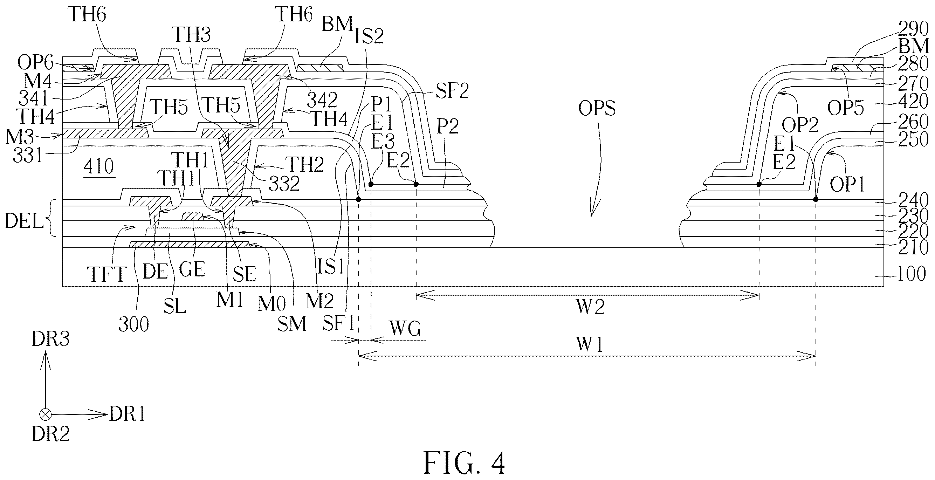

As shown in FIG. 4, after the light shielding layer BM is formed, an inorganic layer 290 (also referred to as the fourth inorganic layer) may be formed on the light shielding layer BM and the inorganic layer 280. In addition, through holes TH6 may be formed in the inorganic layers 280 and 290, such that portions of the conductive patterns 341 and 342 are exposed. In some embodiments, when the transparent display device TD does not include the light shielding layer BM, the transparent display device TD may not include the inorganic layer 290.

Subsequently, the inorganic layers 210, 220, 230, 240, 250, 260, 270, 280, and 290may be patterned to form an opening structure OPS. For example, the inorganic layers 290, 280, 270, 260, 250, 240, 230, 220, and 210 may be sequentially patterned to respectively form openings, wherein the opening structure OPS may be composed of the openings of the inorganic layers. In the direction DR3, the opening structure OPS may overlap the first opening OP1 of the first organic layer 410 and the second opening OP2 of the second organic layer 420. The step of patterning the inorganic layers 210, 220, 230, 240, 250, 260, 270, 280, and 290 may include at least one photolithography process using a single photomask combined with one or more etching processes. The etching process may include dry etching, wet etching, or other processes capable of effectively removing the inorganic layers, but is not limited thereto. The etching solution used in the wet etching process may include, for example, buffered hydrofluoric acid (Buffered HF, BHF) or other suitable etching solutions. For instance, this patterning step may be performed at the same station during the manufacturing process of the transparent display device TD, such as in the same reaction chamber, but is not limited thereto.

As shown in FIG. 5, after the opening structure OPS is formed, the light emitting element 600 may be disposed on the inorganic layer 290. The light emitting element 600 may be bonded to the inorganic layer 290 via bonding pads 510 and 511, and electrically connected to the conductive patterns 341 and 342, respectively. For example, the bonding pads 510 and 511 may be respectively disposed in the through holes TH6 of the inorganic layers 280 and 290, wherein the bonding pads 510 and 511 may be electrically connected to the conductive patterns 341 and 342, respectively. The bonding pads 510 and 511 may, for example, directly contact the conductive patterns 341 and 342, respectively, but not limited thereto. One end of the light emitting element 600 (e.g., one pad of the light emitting element) may be electrically connected to the source electrode SE of the corresponding transistor TFT via the bonding pad 511, and the conductive patterns 342 and 332. The other end of the light emitting element 600 (e.g., another pad of the light emitting element) may be electrically connected to the conductive pattern 331 via the bonding pad 510 and the conductive pattern 341, wherein the conductive pattern 331 may be electrically connected to a voltage source or ground, for example. Through the transistor TFT, a grayscale signal may be transmitted to the light emitting element 600, such that the light emitting element 600 may emit light having a corresponding grayscale value, thereby enabling the transparent display device TD to display an image, but is not limited thereto.

In the embodiment shown in FIG. 5, after the light emitting element 600 is formed, an encapsulation layer 700 may be formed on the light emitting element 600 and the inorganic layer 290, wherein the encapsulation layer 700 may be disposed within the opening structure OPS. Subsequently, a cover layer 800 may be disposed on the encapsulation layer 700 to form the transparent display device TD of this embodiment.

In this embodiment, the substrate 100 may include, for example, a rigid substrate or a flexible substrate. The rigid substrate may include glass, ceramic, quartz, or sapphire, and the flexible substrate may include polyimide (PI), polycarbonate (PC), polyethylene terephthalate (PET), or poly(methyl methacrylate) (PMMA), but is not limited thereto. The inorganic layers 210, 220, 230, 240, 250, 260, 270, 280, and 290 may include, for example, silicon oxide (SiOx), silicon nitride (SiNx), other suitable insulating materials, or combinations thereof.

Taking glass as an example of the material of the substrate 100, since the substrate 100 includes inorganic materials such as silicon oxide, the etching solution used in the etching process for patterning the inorganic layers may also damage the substrate 100. In conventional manufacturing methods, each inorganic layer is etched immediately after its formation to expose the substrate, and multiple above-mentioned etching processes are repeated for the multiple inorganic layers, causing the substrate to be exposed to the etching solution multiples times. This results in significant damage to the substrate, increasing its surface roughness and haze, thereby affecting the transparency and transmittance of the transparent display device. In this embodiment, since the step of patterning the inorganic layers 210, 220, 230, 240, 250, 260, 270, 280, and 290 are not performed immediately after forming each inorganic layer to expose the substrate 100, and the above-mentioned etching process is not repeated multiple times. Instead, the inorganic layers are etched to form the opening structure OPS after the driving element layer DEL and the required organic and inorganic layers are formed. Hence, the number of times the substrate 100 is exposed to the etching solution (e.g., only once exposed to the etching solution for etching the inorganic layer 210) may be reduced. This helps minimize damage to the substrate 100, thereby reducing the surface roughness and haze on the substrate 100 corresponding to the opening structure OPS, and improving the transmittance and/or transparency of the substrate 100 corresponding to the opening structure OPS, but is not limited thereto. Furthermore, since the inorganic layers 210, 220, 230, 240, 250, 260, 270, 280, and 290 may be patterned at the same process station, the probability of substrate 100 having warpage during the manufacturing process may also be reduced, thereby improving the yield of the transparent display device TD, but is not limited thereto. In addition, since the inorganic layers 210, 220, 230, 240, 250, 260, 270, 280, and 290 may be patterned at the same process station, in a cross-sectional view taken along the direction DR1, a sidewall of the opening structure OPS may be, for example, wave-shaped or other suitable shapes, but are not limited thereto.

Refer to FIG. 5 and FIG. 6 together, wherein FIG. 6 schematically illustrates a top view of a transparent display device according to the first embodiment of the present disclosure, and FIG. 5 is a cross-sectional structural diagram taken along a line A-A' of FIG. 6. As shown in FIG. 5 and FIG. 6, this embodiment provides a transparent display device TD, which includes the substrate 100, the inorganic layer 210 disposed on the substrate 100, the driving element layer DEL disposed on the inorganic layer 210, the first organic layer 410 disposed on the driving element layer DEL, the second organic layer 420 disposed on the first organic layer 410, and the light emitting element 600 disposed on the second organic layer 420. The first organic layer 410 includes a side surface SF1, and the second organic layer 420 is disposed on the side surface SF1 of the first organic layer 410.

In the embodiment shown in FIG. 5, in the direction DR1, a width W3 of the opening OP3 (also referred to as the third opening) of the inorganic layer 210 may be less than the width W2 of the second opening OP2 of the second organic layer 420. A width W4 of the opening OP4 (also referred to as the fourth opening) of the inorganic layer 250 may be greater than the width W3 of the opening OP3 of the inorganic layer 210 and less than the width W2 of the second opening OP2 of the second organic layer 420. In addition, the side surface SF2 of the second organic layer 420 may include a bottom edge E2 in contact with the underlying inorganic layer 260, and the sidewall of the opening OP3 etched in the inorganic layer 210 may include a bottom edge E4 in contact with the substrate 100. A width WS may be present between the projections of the bottom edge E2 and the bottom edge E4 on the same projection plane along the direction DR3, wherein the width WS may be less than or equal to 20 micrometers, but is not limited thereto. In some embodiments, the width WS may be 20 micrometers, 15 micrometers, 10 micrometers, 8 micrometers, 5 micrometers, 3 micrometers, or in a range between any two of the aforementioned values, but is not limited thereto. In this embodiment, the openings of the inorganic layers 290, 280, 270, 260, 250, 240, 230, 220, and 210 may all be less than the width W2 of the second opening OP2 of the second organic layer 420.

As shown in FIG. 5 and FIG. 6, the transparent display device TD may include a plurality of transparent regions TR and a non-transparent region NTR. In this embodiment, each of the transparent regions TR may correspond to a region of one of the openings OP5, for example, defined by the opening OP5, and the non-transparent region NTR may be a region outside the transparent regions TR, but is not limited thereto. Each of the transparent regions TR may include an opening portion OPP and a sidewall portion SWP. The opening portion OPP may be a region of the smallest opening among the openings of the inorganic layers corresponding to the opening structure OPS, for example, the region of the opening OP3 of the inorganic layer 210. The sidewall portion SWP may be a region between the edge of the light shielding layer BM adjacent to the opening portion OPP and the bottom edge E4 of the opening OP3 of the inorganic layer 210, viewed along direction DR3, wherein the sidewall portion SWP may surround the opening portion OPP. In the direction DR1, the width WOP of the opening portion OPP may be greater than the width WSW of the sidewall portion SWP. In the embodiment of FIG. 5, the side surface SF1 of the first organic layer 410 may correspond to the sidewall portion SWP. It should be noted that by the configuration of the second organic layer 420 disposed on the side surface SF1 of the first organic layer 410, the distance WG, and/or the width WS, the probability of increasing the width WSW of the sidewall portion SWP due to considerations of critical dimension (CD) and overlay error may be reduced. This may help reduce the width WSW of the sidewall portion SWP, thereby improving the transmittance and/or reducing the haze of the transparent display device TD, but is not limited thereto. In some embodiments, when the transparent display device TD does not include the light shielding layer BM, the non-transparent region NTR may be a region where the conductive layers M0, M1, M2, M3, and M4 distribute in the top-view direction (e.g., direction DR3), and the transparent regions TR may be the regions outside the non-transparent region NTR.

The organic layers of the transparent display device TD are not limited to the first organic layer 410 and the second organic layer 420, and the number of organic layers may be three or more. When multiple organic layers are present, the width of the opening of an upper organic layer (or a layer further from the substrate 100) may be less than the width the opening of a lower organic layer (or a layer closer to the substrate 100).

It should be noted that a ratio of the width WOP of the opening portion OPP to the width WSW of the sidewall portion SWP may be greater than or equal to 5 and less than or equal to 50 to improve the transmittance of the transparent display device TD, but is not limited thereto. For example, when the pixels per inch (PPI) of the transparent display device TD is approximately 150, the ratio of the width WOP to the width WSW may be about 5; when the PPI is approximately 60, the ratio may be about 19; or when the PPI is approximately 37, the ratio may be about 30, but is not limited thereto. In some embodiments, when the transparent display device TD does not include the light shielding layer BM and the conductive layer M4 includes black metal, the sidewall portion SWP may be defined as the region between the edge of the conductive pattern 342 adjacent to the opening portion OPP and the bottom edge E4 of the opening OP3 of the inorganic layer 210, but is not limited thereto.

As shown in FIG. 6, the transparent regions TR may be separated from each other by the non-transparent region NTR. The transparent display device TD may include a plurality of light emitting elements 600, wherein a single transparent region TR surrounded by the non-transparent region NTR and three corresponding light emitting elements 600 arranged along the direction DR2 may constitute one pixel, but is not limited thereto. The number of light emitting elements 600 in one pixel is not limited to three. The light emitting elements 600 in one pixel may include light emitting elements of the same or different colors as needed. It should be noted that FIG. 6 illustrates the contour of the transparent region TR as a quasi-rectangular shape, but is not limited thereto. In some embodiments, the contour of the transparent region TR may be polygonal, annular, star-shaped, dagger-shaped, or other suitable shapes.

In the present disclosure, the conductive layers M0, M1, M2, M3, and M4 may include, for example, metal or other suitable conductive materials. The metal may include titanium (Ti), platinum (Pt), gold (Au), nickel (Ni), aluminum (Al), molybdenum (Mo), copper (Cu), alloys of the aforementioned materials, or other suitable metallic materials, but is not limited thereto. For example, the thicknesses of the conductive layers M0, M1, M2, M3, and M4 in the direction DR3 may each be greater than or equal to 0.3 micrometers and less than or equal to 3 micrometers. In some embodiments, each of the thicknesses of the conductive layers M3 and M4 in the direction DR3 may further be greater than or equal to 1 micrometer, 1.5 micrometers, 1.8 micrometers, 2 micrometers, 2.3 micrometers, or 2.5 micrometers. In some embodiments, the thickness of the conductive layer M3 may be greater than that of at least one of the conductive layers M0, M1, and M2, and/or the thickness of the conductive layer M4 may be greater than that of at least one of the conductive layers M0, M1, and M2, but is not limited thereto. Furthermore, in the present disclosure, the conductive layers M0, M1, M2, M3, and M4 may each be a single-layer or multi-layer structure, but are not limited thereto. The conductive patterns 300, 331, 332, 341, and/or 342 may have functions such as signal transmission, light shielding, electric field shielding, signal interference shielding, or combinations thereof. In some embodiments, the conductive patterns may serve as shielding patterns, electrodes, or pads, but are not limited thereto. The first organic layer 410 and the second organic layer 420 may include, for example, polyimide (PI), photosensitive polyimide (PSPI), epoxy, polymer, or other suitable materials. The light emitting element 600 may include, for example, a light emitting diode or other suitable light emitting elements, but is not limited thereto. The encapsulation layer 700 may include, for example, encapsulation materials or other suitable materials, wherein the encapsulation material may include epoxy molding compound (EMC) or other suitable organic materials, but is not limited thereto. The cover layer 800 may include, for example, the same material as the substrate 100, but is not limited thereto. The bonding pads 510 and 511 may include, for example, solder balls, nickel, gold, copper, gallium, or other suitable conductive materials.

The transparent display device and the manufacturing method thereof of the present disclosure are not limited to the above embodiments and may include different embodiments. For simplicity of explanation, the following embodiments will use the same reference numerals as those in the first embodiment to denote identical elements. To clearly describe the differences among the various embodiments, the following content will focus on the distinctions between the embodiments, and repeated portions will not be described again.

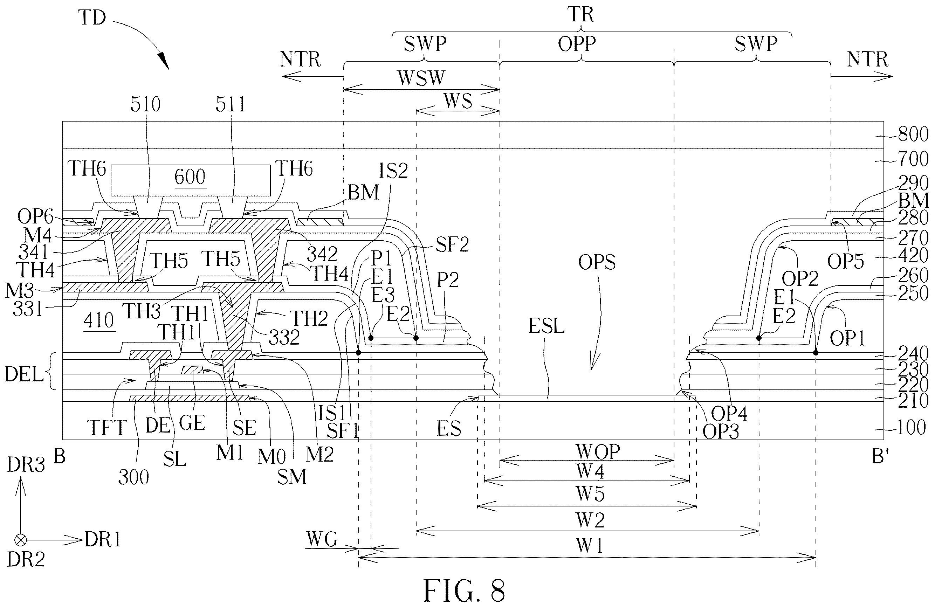

Refer to FIG. 7 and FIG. 8 together, wherein FIG. 7 schematically illustrates a top view of a transparent display device according to a second embodiment of the present disclosure, FIG. 8 schematically illustrates a cross-sectional view of a transparent display device according to the second embodiment of the present disclosure, and FIG. 8 is a cross-sectional schematic diagram taken along a line B - B' of FIG. 7. The difference between the manufacturing method of the transparent display device TD in this embodiment and that of the first embodiment lies in that, prior to forming the inorganic layer 210, an etching stop layer ES may be formed on the substrate 100. The etching stop layer ES may include a plurality of etching stop patterns ESL, and at least a portion of one of the etching stop patterns ESL may correspond to at least one of the transparent regions TR. In this embodiment, the etching stop patterns ESL may, for example, respectively correspond to the opening portions OPP of the transparent regions TR. Since the etching stop layer ES and the conductive layer M0 include different materials, the etching stop layer ES may be formed either before or after the formation of the conductive layer M0. In this embodiment, the etching stop layer ES may include, for example, indium tin oxide (ITO), graphene, polyimide (PI), a combination of the aforementioned materials, or other suitable transparent materials, but is not limited thereto. Subsequently, the inorganic layer 210 may be formed on the substrate 100 and cover the conductive patterns 300 and the etching stop layer ES. That is, the etching stop patterns ESL may be disposed between the substrate 100 and the inorganic layer 210. The steps from the formation of the inorganic layer 210 to the formation of the opening structure OPS may be the same as those in the above-described embodiment and will not be repeated here.

Next, the inorganic layers 210, 220, 230, 240, 250, 260, 270, 280, and 290 may be patterned to form the opening structure OPS. It should be noted that, since the etching stop patterns ESL are disposed on the substrate 100 and correspond to the opening structures OPS, when the inorganic layer 210 is etched, the etching stop patterns ESL may prevent the substrate 100 from being damaged by the etching solution used for etching the inorganic layer 210, thereby improving the transparency of the substrate 100 corresponding to the opening structure OPS, but is not limited thereto. In this embodiment, since the etching stop patterns ESL are disposed between the substrate 100 and the inorganic layer 210, the patterning process of the inorganic layers may include, for example, a wet etching process to improve removal efficiency, but is not limited thereto. In some embodiments, the patterning process may also include a dry etching process or other suitable processes.

Furthermore, since the etching stop patterns ESL in this embodiment may include the aforementioned transparent material, the etching stop patterns ESL may remain after the formation of the opening structure OPS, but are not limited thereto. In some embodiments, the transparent material of the etching stop patterns ESL may have a high etching selectivity ratio compared to the inorganic layer 210, such that damage to the etching stop patterns ESL during the formation of the opening structure OPS may be reduced, thereby minimizing the impact on the transparency of the transparent display device TD.

In this embodiment, as shown in FIG. 7 and FIG. 8, the etching stop pattern ESL may be disposed within the opening portion OPP of the transparent region TR, and a portion of the etching stop pattern ESL may extend into the sidewall portion SWP of the transparent region TR. That is, in the direction DR1, a width W5 of the etching stop pattern ESL may be greater than the width WOP of the opening portion OPP, but is not limited thereto. In some embodiments, the width W5 may be equal to the width WOP. Alternatively, the top-view area of the etching stop pattern ESL may be greater than or equal to the top-view area of the opening portion OPP. The other parts of this embodiment (e.g., the steps after the formation of the opening structure OPS) may be the same as those in the above-described embodiment and will not be repeated here. In some embodiments, after the formation of the opening structure OPS, another etching process may be performed on the etching stop patterns ESL to remove the portion of the etching stop pattern ESL exposed by the opening structure OPS, thereby exposing the substrate 100. Since the material of the etching stop layer ES may have a high etching selectivity ratio compared to the substrate 100, damage to the substrate 100 during the etching process of the etching stop patterns ESL may be reduced.

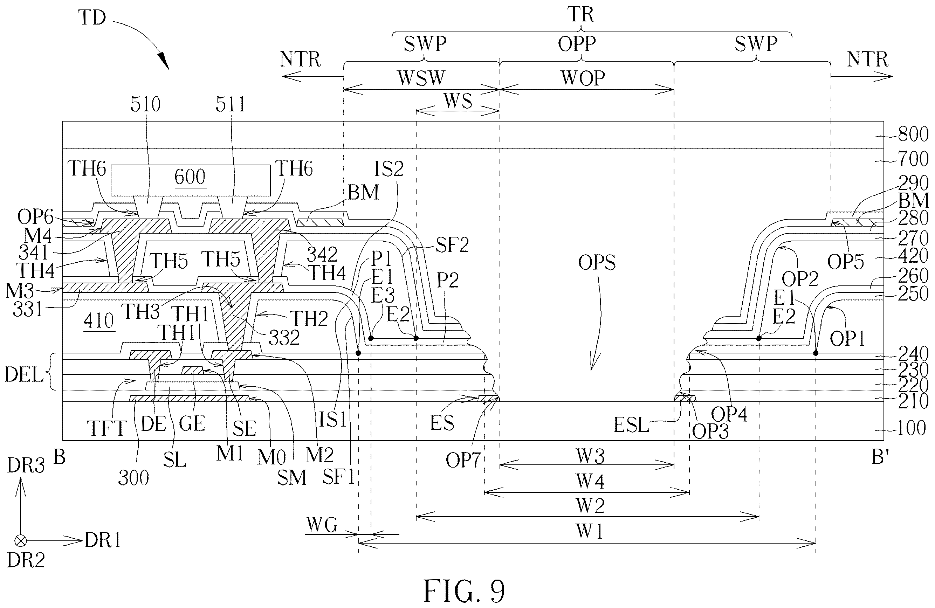

Refer to FIG. 9. FIG. 9 schematically illustrates a cross-sectional view of a transparent display device according to a variant embodiment of the second embodiment of the present disclosure. The difference between the manufacturing method of the transparent display device TD of this variant embodiment and that of the embodiment shown in FIG. 7 and FIG. 8 lies in that the etching stop pattern ESL may include opaque metal. The metal may include, for example, titanium, platinum, gold, nickel, aluminum, molybdenum, copper, alloys of the aforementioned materials, or other suitable metallic materials, but is not limited thereto. Furthermore, in this embodiment, the etching stop pattern ESL and the conductive pattern 300 may be formed of the same conductive layer M0. In other words, the etching stop pattern ESL may include the same material as the conductive layer M0, or the etching stop pattern ESL may be formed simultaneously with the conductive pattern 300, but is not limited thereto. In some embodiments, the etching stop pattern ESL may be formed before or after the conductive pattern 300 are formed. The steps from the formation of the etching stop pattern ESL to the placement of the light emitting element 600 may be the same as those in the aforementioned embodiments and will not be repeated here.

After the opening structure OPS is formed, since the etching stop pattern ESL shields the portion of the substrate 100 corresponding to the opening structure OPS, the etching stop pattern ESL may prevent the substrate 100 from being damaged by the etching solution used for etching the inorganic layer 210. Subsequently, another etching process may be performed on a portion of the etching stop pattern ESL exposed by the opening structure OPS to form an opening OP7, wherein a size of the opening OP7 may be approximately the same as that of the opening OP3 of the inorganic layer 210, but is not limited thereto. It should be noted that, since the etching stop pattern ESL includes metallic materials, and the etching solution of the metallic material causes less damage to the substrate 100, the surface roughness on the substrate 100 corresponding to the opening structure OPS may be reduced, thereby improving the transmittance and/or transparency of the substrate 100 corresponding to the opening structure OPS, but is not limited thereto. Moreover, since the width W5 of the etching stop pattern ESL may be greater than the width WOP of the opening portion OPP, a portion of the etching stop pattern ESL may remain in the sidewall portion SWP of the transparent region TR after etching. In addition, as light tends to scatter when passing through the inorganic layers and their side surfaces within the sidewall portion SWP, leaving the etching stop pattern ESL in the sidewall portion SWP may reduce the haze of the transparent region TR, thereby enhancing the user experience, but is not limited thereto. In some embodiments, the etching stop pattern ESL may extend to overlap the light shielding layer BM in the direction DR3, thereby reducing the amount of scattered light passing through the transparent display device TD, which may reduce the haze of the transparent region TR and improve the user experience. Subsequently, the light emitting element 600 may be disposed on the inorganic layer 290. The other parts of this embodiment (e.g., the steps after the placement of the light emitting element 600) may be the same as those in the aforementioned embodiments and will not be repeated here.

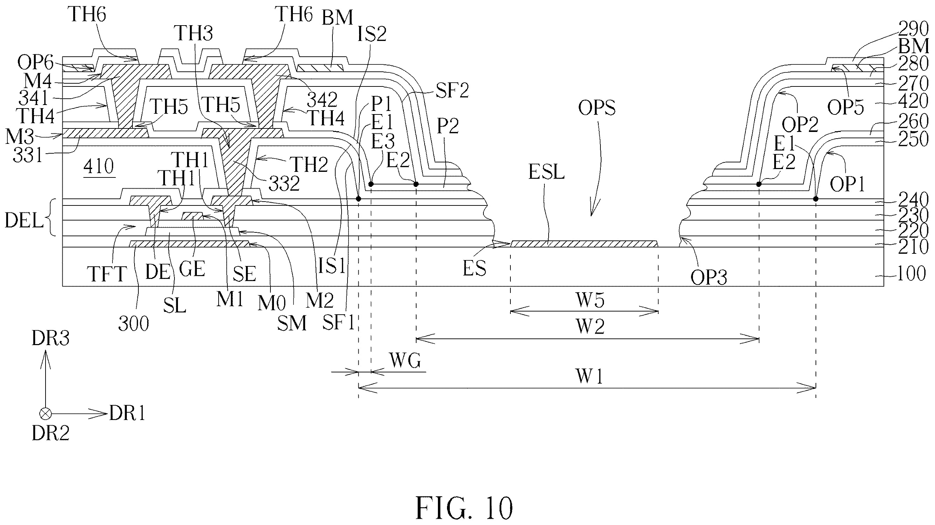

Refer to FIG. 10, and also to FIG. 5. FIG. 10 is a schematic cross-sectional view in one step of a manufacturing method of a transparent display device according to the third embodiment of the present disclosure. The difference between the manufacturing method of the transparent display device TD in this embodiment and that of the embodiment shown in FIG. 7 and FIG. 8 lies in that the width W5 of the etching stop pattern ESL may be less than the width WOP of the opening portion OPP of the transparent region TR shown in FIG. 5. For example, the width W5 of the etching stop pattern ESL may be less than the width W3 of the opening OP3 of the inorganic layer 210. In this case, during the step of forming the opening structure OPS, since the etching stop pattern ESL is on a portion of the substrate 100 corresponding to the opening structure OPS, damage to the substrate 100 caused by the etching solution may be reduced. Additionally, another portion of the substrate 100 corresponding to the opening structure OPS is not covered by the etching stop pattern ESL, but this portion is etched after the required inorganic layers are formed thereon. Therefore, the number of times this portion is exposed to the etching solution used for inorganic layers may be reduced, which helps minimize the surface roughness on the substrate 100 corresponding to the opening structure OPS, thereby improving the transmittance and/or transparency of the substrate 100 corresponding to the opening structure OPS, but is not limited thereto.

Another difference between this embodiment and the second embodiment is that the etching stop pattern ESL may include metal. The metal may include, for example, titanium, platinum, gold, nickel, aluminum, molybdenum, copper, alloys of the aforementioned materials, or other suitable metallic materials, but is not limited thereto. Therefore, after the opening structure OPS is formed, another etching process may be performed on the etching stop pattern ESL to remove it. Since the etching solution for metallic materials causes less damage to the substrate 100, the surface roughness on the substrate 100 corresponding to the opening structure OPS may be reduced, thereby improving the transparency of the substrate 100 corresponding to the opening structure OPS, but is not limited thereto.

As shown in FIG. 5, after the etching stop pattern ESL is removed, the light emitting element 600 may be disposed on the inorganic layer 290. The other parts of this embodiment (e.g., the steps after the placement of the light emitting element 600) may be the same as those in the aforementioned embodiments and will not be repeated here.

In summary, in the manufacturing method of the transparent display device of the present disclosure, since the inorganic layers are etched to form the opening structure after the required inorganic layers are formed, the number of times the substrate is exposed to the etching solution used for inorganic layers may be reduced. This helps minimize damage to the substrate, thereby reducing the surface roughness and haze on the substrate corresponding to the opening structure, and improving the transparency of the substrate corresponding to the opening structure. Furthermore, since the width of the opening of the upper organic layer may be less than the width of the opening of the lower organic layer, the width of the sidewall portion of the transparent region may be reduced, thereby improving the transmittance and/or reducing the haze of the transparent display device. In one embodiment of the present disclosure, since the etching stop pattern is formed on the portion of the substrate corresponding to the opening structure before the inorganic layers are formed, the probability of substrate damaged by the etching solution may be reduced, thereby improving the transmittance and/or transparency of the substrate corresponding to the opening structure. In another embodiment, the etching stop pattern utilizing the light shielding material may further reduce scattered light passing through the sidewall portion of the transparent region, thereby reducing the haze of the transparent display device and enhancing the user experience.

## Claims

1. A transparent display device (TD), **characterized by**
a substrate (100);
a first inorganic layer (210) disposed on the substrate (100);
a driving element layer (DEL) disposed on the first inorganic layer (210);
a first organic layer (410) disposed on the driving element layer (DEL) and comprising a side surface (SF1);
a second organic layer (420) disposed on the first organic layer (410), wherein the second organic layer (420) is disposed on the side surface (SF1) of the first organic layer (410); and
a light emitting element (600) disposed on the second organic layer (420).

2. The transparent display device (TD) according to claim 1, further comprising a non-transparent region (NTR) and a plurality of transparent regions (TR), wherein the plurality of transparent regions (TR) are separated from each other by the non-transparent region (NTR), at least one of the plurality of transparent regions (TR) comprises an opening portion (OPP) and a sidewall portion (SWP), a width (WOP) of the opening portion (OPP) is greater than a width (WSW) of the sidewall portion (SWP) in a cross-sectional direction (DR1), and the side surface (SF1) of the first organic layer (410) corresponds to the sidewall portion (SWP).

3. The transparent display device (TD) according to claim 2, further comprising an etching stop pattern (ESL) disposed between the substrate (100) and the first inorganic layer (210), wherein at least a portion of the etching stop pattern (ESL) corresponds to the at least one of the plurality of transparent regions (TR).

4. The transparent display device (TD) according to claim 1 or 2, further comprising a second inorganic layer (250, 260) disposed between the first organic layer (410) and the second organic layer (420), wherein the second inorganic layer (250, 260) comprises an inclined surface (IS1, IS2) corresponding to the side surface (SF1) of the first organic layer (410), and the second organic layer (420) is disposed on the inclined surface (IS1, IS2) of the second inorganic layer (250, 260).

5. The transparent display device (TD) according to claim 4, wherein the first organic layer (410) comprises a first opening (OP1), the second organic layer (420) comprises a second opening (OP2), and in a cross-sectional direction (DR1), a width (W2) of the second opening (OP2) is less than a width (W1) of the first opening (OP1).

6. The transparent display device (TD) according to claim 5, wherein first inorganic layer (210) comprises a third opening (OP3), and in the cross-sectional direction (DR1), a width (W3) of the third opening (OP3) is less than the width (W2) of the second opening (OP2).

7. The transparent display device (TD) according to claim 6, wherein the second inorganic layer (250, 260) comprises a fourth opening (OP4), and in the cross-sectional direction (DR1), a width (W4) of the fourth opening (OP4) is greater than the width (W3) of the third opening (OP3) and less than the width (W2) of the second opening (OP2).

8. A manufacturing method of a transparent display device (TD), **characterized by**:
providing a substrate (100);
forming a first inorganic layer (210) on the substrate (100);
forming a driving element layer (DEL) on the first inorganic layer (210);
forming a first organic layer (410) on the driving element layer (DEL);
patterning the first organic layer (410) to form a first opening (OP1) and a first side surface (SF1);
forming a second inorganic layer (250, 260) on the first organic layer (410), wherein the second inorganic layer (250, 260) covers the first side surface (SF1) of the first organic layer (410) and the first inorganic layer (210);
forming a second organic layer (420) on the second inorganic layer (250, 260), wherein the second organic layer (420) is disposed on the first side surface (SF1) of the first organic layer (410);
forming a third inorganic layer (280) on the second organic layer (420), wherein the third inorganic layer (280) covers the second inorganic layer (250, 260);
patterning the first inorganic layer (210), the second inorganic layer (250, 260), and the third inorganic layer (280) to form an opening structure (OPS), wherein the opening structure (OPS) overlaps the first opening (OP1); and
disposing a light emitting element (600) on the third inorganic layer (280).

9. The manufacturing method of the transparent display device (TD) according to claim 8, further comprising patterning the second organic layer (420) to form a second opening (OP2) and a second side surface (SF2), wherein the second opening (OP2) overlaps the first opening (OP1), and a width (W2) of the second opening (OP2) is less than a width (W1) of the first opening (OP1).

10. The manufacturing method of the transparent display device (TD) according to claim 8 or 9, wherein in a cross-sectional view, a sidewall of the opening structure (OPS) is wave-shaped.

11. The manufacturing method of the transparent display device (TD) according to any one of claims 8 to 10, further comprising forming an etching stop pattern (ESL) on the substrate (100) before the first inorganic layer (210) is formed, wherein the etching stop pattern (ESL) is disposed between the substrate (100) and the first inorganic layer (210).

12. The manufacturing method of the transparent display device (TD) according to claim 11, further comprising forming a conductive pattern (300) on the substrate (100), wherein the conductive pattern (300) comprises a same material as the etching stop pattern (ESL).

13. The manufacturing method of the transparent display device (TD) according to claim 12, further comprising forming an opening (OP7) of the etching stop pattern (ESL) after the opening structure (OPS) is formed, wherein the opening (OP7) of the etching stop pattern (ESL) overlaps the opening structure (OPS).

14. The manufacturing method of the transparent display device (TD) according to any one of claims 8 to 13, further comprising:
forming a light shielding layer (BM) on the third inorganic layer (280); and
forming a fourth inorganic layer (290) on the light shielding layer (BM).

15. The manufacturing method of the transparent display device (TD) according to claim 14, wherein the opening structure (OPS) is formed by patterning the first inorganic layer (210), the second inorganic layer (250, 260), the third inorganic layer (280), and the fourth inorganic layer (290).
